# FASCICULE DE BREVET EUROPEEN

(11) **EP 2 637 966 B1**
(45) Date de publication et mention de la délivrance du brevet: **17.04.2019**
(21) Numéro de dépôt: 11784964.6
(22) Date de dépôt: 31.10.2011
(51) Int. Cl.: B81C 1/00, H01L 23/26, H01L 21/50, H01L 23/10

(54) **PROCEDE DE REALISATION DE SUBSTRAT A COUCHES ENFOUIES DE MATERIAU GETTER**
VERFAHREN ZUR HERSTELLUNG EINES SUBSTRATS MIT EINGEBETTETEN SCHICHTEN AUS FANGSTOFF
METHOD FOR THE PRODUCTION OF A SUBSTRATE COMPRISING EMBEDDED LAYERS OF GETTER MATERIAL

(30) Priorité: 09.11.2010 FR 1059246
(43) Date de publication de la demande: 18.09.2013
(73) Titulaire: Commissariat à l'Énergie Atomique et aux Énergies Alternatives, 75015 Paris (FR)
(72) Inventeur: BAILLIN, Xavier, F-38920 Crolles (FR)
(74) Mandataire: Ilgart, Jean-Christophe
(86) Numéro de dépôt international: PCT/EP2011/069080
(87) Numéro de publication internationale: WO 2012/062613

(56) Documents cités:
- EP-A2- 1 640 327
- EP-A2- 2 308 797
- FR-A1- 2 922 202
- US-A1- 2006 283 546
- US-A1- 2007 262 428
- US-A1- 2008 038 861

## Description

### DOMAINE TECHNIQUE

L'invention concerne le domaine des matériaux getter utilisés pour absorber et/ou adsorber des gaz dans un environnement clos. L'invention concerne notamment un procédé de réalisation d'un substrat à couches de matériaux getter enfouies, c'est-à-dire disposées entre d'autres couches du substrat.

L'invention s'applique également pour la réalisation de micro-dispositifs comportant un ou plusieurs microsystèmes par exemple de type MEMS (microsystèmes électromécaniques) et/ou NEMS (nanosystèmes électromécaniques) ou de type détecteur infrarouge, tels que des micro-bolomètres, réalisés sur un substrat à couches de matériaux getter enfouies et destinés à être encapsulés.

### ÉTAT DE LA TECHNIQUE ANTÉRIEURE

Certains microsystèmes tels que les microsystèmes de types MEMS et/ou NEMS, ou les micro-détecteurs infrarouge, nécessitent pour leur bon fonctionnement d'être enfermés dans une cavité dont l'atmosphère (nature du gaz, pression) est contrôlée.

La technologie utilisée à ce jour pour réaliser une telle encapsulation consiste à réaliser ces microsystèmes collectivement sur une tranche (wafer) de silicium, appelé ici premier substrat. La cavité dans laquelle chacun des microsystèmes est destiné à être encapsulé est obtenue par report et scellement hermétique d'un capot, généralement formé par un autre wafer de silicium, appelé second substrat, sur le premier substrat. Cet assemblage hermétique réalisé entre les deux substrats et formant les cavités d'encapsulation des microsystèmes permet notamment de contrôler les fuites de gaz entre l'intérieur des cavités et l'environnement extérieur. L'ajout de getters non évaporable (NEG) dans les cavités, par exemple sous la forme d'une portion mince préalablement déposée sur l'un des deux substrats, permet de contrôler l'atmosphère (gaz et pression) au sein des cavités.

La réalisation d'une cavité sous atmosphère contrôlée dans laquelle est encapsulé un microsystème nécessite donc la mise en oeuvre d'un dépôt d'un getter sur l'un ou l'autre des deux substrats préalablement à l'opération d'assemblage, comme décrit dans le document US 2003/052392 A1. Dans ce document, le matériau getter est présent dans la cavité au travers d'une fenêtre découvrant en partie ce getter. Toutefois, cette solution ne permet pas l'obtention d'un vide poussé, ou important, dans la cavité. De plus, le matériau getter est exposé à toutes les étapes technologiques, depuis la réalisation du microsystème jusqu'à l'encapsulation et la fermeture de la cavité, ce qui peut le détériorer et réduire sa capacité de pompage des gaz.

De façon plus générale, la réalisation du getter nécessite la mise en oeuvre d'opérations technologiques de dépôt et de gravure afin de mettre en forme le getter en deux dimensions. Une variante peut consister à déposer le getter directement sous la forme souhaitée par pochoir, par l'intermédiaire d'un masque dur ou d'un film de résine photosensible (lift-off). Dans tous les cas, ces étapes représentent un coût important dans la réalisation de l'encapsulation. De plus, ces étapes présentent également un risque pour le getter en raison de sa compatibilité chimique avec les produits utilisés pour réaliser ces opérations.
Le document US 2008/0038861 A1 décrit un substrat comprenant une couche de matériau getter enfouie entre deux support.

### EXPOSÉ DE L'INVENTION

Un but de la présente invention est de proposer un nouveau type de substrat à partir duquel il est possible de réaliser et d'encapsuler un dispositif, ou micro-dispositif, tel qu'un microsystème, dans une cavité comportant au moins un matériau getter ne nécessitant pas la mise en oeuvre d'étapes spécifiques liées à la mise en forme du getter, présentant de meilleures capacités de pompage gazeux et ne nécessitant pas la mise en oeuvre d'étapes pouvant détériorer le getter.

Pour cela, la présente invention propose un procédé de réalisation d'un substrat à couches de matériau getter enfouies, comprenant au moins les étapes de :
- réalisation d'un premier empilement comportant au moins une couche d'un premier matériau getter disposée sur l'ensemble de la surface d'une face d' un premier support,
- réalisation d'un second empilement comportant au moins une couche d'un second matériau getter disposée sur l'ensemble de la surface d'une face d' un second support,
- mise en contact et thermocompression du premier empilement contre le second empilement, les couches du premier et du second matériau getter étant disposées entre le premier et le second support, à une température supérieure ou égale à la température la plus basse parmi les températures d'activation thermique du premier et du second matériau getter, de façon à solidariser les couches du premier et du second matériau getter entre elles.

Le substrat ainsi obtenu permet de s'affranchir des problèmes liés à la mise en forme des matériaux getter étant donné que ce matériau getter est déjà présent dans le substrat sous la forme de couches enfouies.

Un tel substrat comportant deux couches de matériau getter présente de meilleures propriétés d'absorption gazeuse qu'une structure comportant une unique couche de matériau getter.

De plus, étant donné que le ou les matériaux getter sont présents dans le substrat sous la forme de couches enfouies, ils sont donc également protégés pendant des opérations technologiques ultérieures, par exemple lors d'une réalisation d'un dispositif tel qu'un microsystème sur ce substrat, empêchant une détérioration du matériau getter.

La solidarisation par thermocompression permet également, lorsqu'aucune couche de protection ne recouvre les couches de matériau getter, de supprimer les éventuelles couches natives d'oxyde et/ou de nitrure recouvrant les matériaux getter.

On entend par « température d'activation thermique » d'un matériau getter la température à partir de laquelle, lorsque ce matériau getter est exposé à cette température, celui-ci présente des propriétés d'absorption et/ou d'adsorption gazeuse.

L'étape de thermocompression est de préférence réalisée à une pression de quelques MPa, et par exemple supérieure à 1 MPa.

Le premier empilement peut comporter en outre une couche de protection du premier matériau getter disposée sur la couche du premier matériau getter, et/ou le second empilement peut comporter en outre une couche de protection du second matériau getter disposée sur la couche du second matériau getter, l'étape de mise en contact et de thermocompression pouvant permettre de faire diffuser la ou les couches de protection avec la ou les couches de matériau getter sur lesquelles sont disposées les couches de protection.

Cette diffusion se produit soit depuis la couche de protection vers la couche de matériau getter, soit inversement depuis la couche de matériau getter vers la couche de diffusion.

Grâce à la ou aux couches de protection formées sur l'une ou les couches de matériau getter, la capacité d'absorption et/ou d'adsorption de la ou des couches de matériau getter n'est pas altérée lors de la réalisation du substrat.

Lorsqu'au moins l'une des couches de matériau getter est recouverte par une couche de protection, la température d'activation thermique de la couche de matériau getter protégée peut correspondre alors à la température à laquelle cette couche de protection diffuse avec la couche de matériau getter.

Les matériaux getter de la première et de la seconde couche peuvent être identiques ou différents.

La couche de protection du premier matériau getter et/ou la couche de protection du second matériau getter peuvent comporter de l'oxyde et/ou du nitrure, par exemple de l'oxyde et/ou du nitrure du premier et/ou du second matériau getter.

La couche de protection du premier matériau getter et/ou la couche de protection du second matériau getter peuvent être réalisées par oxydation et/ou nitruration de la couche du premier matériau getter et/ou de la couche du second matériau getter sous atmosphère sèche de dioxygène et/ou de diazote.

Le premier support et/ou le second support peuvent comporter au moins un semi-conducteur.

Le premier matériau getter et/ou le second matériau getter peuvent comporter du titane et/ou du zirconium et/ou du vanadium et/ou du niobium et/ou du tantale.

L'étape de mise en contact et de thermocompression du premier empilement contre le second empilement peut être mise en oeuvre sous vide secondaire.

Le procédé peut comporter en outre, après l'étape de mise en contact et de thermocompression, une étape d'amincissement et/ou de polissage du premier support et/ou du second support.

Le premier empilement peut comporter en outre une première couche diélectrique et/ou une couche d'accroche comprenant du titane et/ou du zirconium disposées entre le premier support et la couche du premier matériau getter, et/ou le second empilement peut comporter en outre une deuxième couche diélectrique et/ou une couche d'accroche comprenant du titane et/ou du zirconium disposées entre le second support et la couche du second matériau getter.

Le premier et/ou le second empilement peuvent comporter en outre au moins une couche de cuivre et/ou de nickel et/ou de platine et/ou d'argent et/ou de ruthénium et/ou de chrome et/ou d'or et/ou d'aluminium disposée entre le premier support et la couche du premier matériau getter et/ou entre le second support et la couche du second matériau getter.

Le procédé peut comporter en outre, après la réalisation du premier et du second empilement et avant l'étape de mise en contact et de thermocompression, une étape de dégazage des faces desdits empilements destinées à être mises en contact l'une contre l'autre.

Lorsque le premier et/ou le second empilement ne comporte pas de couche de protection, il est possible qu'une couche d'oxyde se forme en surface du premier et/ou du second matériau getter si ce ou ces matériaux getter sont exposés à l'air. Dans ce cas, on peut mettre en oeuvre une étape de dissolution par traitement thermique de cette couche d'oxyde préalablement à l'étape de mise en contact et de thermocompression.

Le procédé peut comporter en outre, lors de la réalisation du premier empilement et/ou lors de la réalisation du second empilement, une étape d'amincissement et/ou de polissage de la couche du premier matériau getter et/ou de la couche du second matériau getter (par exemple mise en oeuvre avant la réalisation de la ou des couches de protection), et/ou, lorsque le premier et/ou le second empilement comportent la couche de protection du premier matériau getter et/ou la couche de protection du second matériau getter, une étape de traitement hydrophile de la couche de protection du premier matériau getter et/ou de la couche de protection du second matériau getter. Un tel traitement hydrophile améliore l'assemblage réalisé entre les deux empilements.

L'invention concerne également un procédé de réalisation d'un dispositif, comportant au moins les étapes suivantes :
- mise en oeuvre d'un procédé de réalisation d'un premier substrat tel que décrit précédemment,
- réalisation d'un micro-dispositif, par exemple un microsystème, sur le premier substrat ou sur un second substrat,
- gravure d'une partie du premier substrat, dévoilant une partie de la couche du premier matériau getter et/ou une partie de la couche du second matériau getter,
et comportant en outre, lorsque le micro-dispositif ou microsystème est réalisé sur le premier substrat, une étape d'encapsulation du micro-dispositif ou du microsystème dans une cavité formée entre le premier substrat et un capot solidarisé au premier substrat, ou, lorsque le micro-dispositif ou le microsystème est réalisé sur le second substrat, une étape d'encapsulation du micro-dispositif ou du microsystème dans une cavité formée entre le second substrat et le premier substrat solidarisé au second substrat, ladite partie de la couche du premier matériau getter et/ou ladite partie de la couche du second matériau getter étant disposée dans la cavité.

Lorsque le procédé de réalisation du premier substrat comporte une étape d'amincissement et/ou de polissage du second support, le micro-dispositif ou le microsystème peut être réalisé dans et/ou sur le second support aminci et/ou poli.

Dans une première variante le capot peut comporter une couche mince de matériau.

Dans une seconde variante, le capot peut comporter un substrat obtenu par la mise en oeuvre d'un procédé de réalisation d'un substrat tel que décrit précédemment.

Le procédé de réalisation du substrat tel que décrit précédemment aboutit à un substrat à couches de matériau getter enfouies, comprenant au moins :
- un premier empilement comportant au moins une couche d'un premier matériau getter disposée l'ensemble de la surface d'une face d'un premier support,
- un second empilement comportant au moins une couche d'un second matériau getter disposée sur l'ensemble de la surface d'une face d'un second support,
les couches du premier et du second matériau getter étant solidarisées entre elles et disposées entre le premier et le second support.

Les couches du premier et du second matériau getter forment les couches de matériau getter enfouies entre le premier support et le second support. Ainsi, on obtient le substrat qui comprend les couches du premier et du second matériau getter entièrement enterrées entre le premier et le second support.

Les couches du premier et du second matériau getter sont thermocompressées l'une contre l'autre.

La couche du premier matériau getter et/ou la couche du second matériau getter peuvent comporter en outre des particules dissoutes d'oxygène et/ou d'azote.

Le procédé de réalisation du dispositif tel que décrit précédemment aboutit à un dispositif comportant au moins un microsystème réalisé sur un premier substrat tel que décrit précédemment ou sur un second substrat et encapsulé, lorsque le microsystème est réalisé sur le premier substrat, dans une cavité formée entre le premier substrat et un capot solidarisé au premier substrat ou, lorsque le microsystème est réalisé sur le second substrat, dans une cavité formée entre le second substrat et le premier substrat solidarisé au second substrat, une partie de la couche du premier matériau getter et/ou une partie de la couche du second matériau getter mise à nue étant disposée dans la cavité.

Le capot peut comporter une couche mince de matériau ou un substrat tel que définit précédemment.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1D représentent les étapes d'un procédé de réalisation d'un substrat à couches enfouies de matériau getter selon un premier mode de réalisation,
- les figures 2A et 2B représentent des étapes d'un procédé de réalisation d'un substrat à couches enfouies de matériau getter selon un second mode de réalisation,

- les figures 3A et 3B représentent des étapes d'un procédé de réalisation d'un substrat à couches enfouies de matériau getter selon un troisième mode de réalisation,
- les figures 4A à 4H représentent des micro-dispositifs comportant des microsystèmes encapsulés et réalisés selon un procédé objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

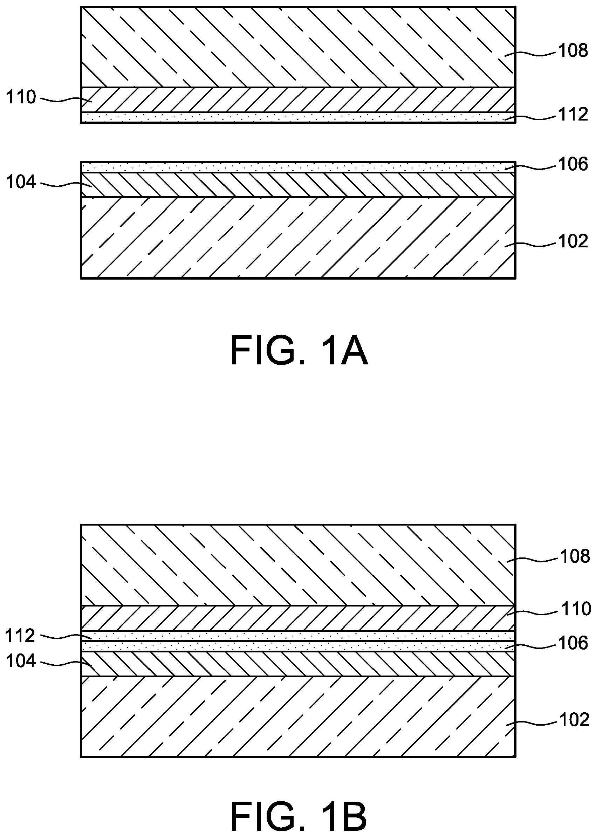

On se réfère tout d'abord aux figures 1A à 1D qui représentent les étapes d'un procédé de réalisation d'un substrat 100 à couches enfouies de matériau getter selon un premier mode de réalisation.

Comme représenté sur la figure 1A, on réalise sur un premier support 102, formé par exemple par un substrat comprenant un semi-conducteur tel que du silicium, une première couche 104 comprenant un matériau getter. Ce matériau getter peut être n'importe quel matériau métallique pouvant présenter des propriétés d'absorption et/ou d'adsorption gazeuse après activation thermique, par exemple du titane et/ou du zirconium et/ou du vanadium et/ou du niobium et/ou du tantale et/ou un alliage de plusieurs de ces métaux.

Une telle couche 104 de matériau getter est par exemple réalisée par un dépôt de type PVD (dépôt physique en phase vapeur), pulvérisation ou évaporation, sur l'ensemble de la surface du premier support 102 (dépôt pleine plaque). L'épaisseur de la couche de matériau getter 104 est ici comprise entre environ 100 nm et 2 µm.

La couche getter 104 est ensuite recouverte d'une couche de protection 106 évitant au matériau getter de la couche 104 d'être exposé à l'air ambiant et d'absorber les gaz de l'air ambiant (oxygène, azote, monoxyde et dioxyde de carbone) ainsi que la vapeur d'eau présente dans l'air ambiant. Cette couche de protection 106 comporte par exemple de l'oxyde et/ou du nitrure du matériau getter de la couche 104.

Une telle couche de protection 106 est par exemple obtenue par une oxydation et/ou une nitruration du matériau getter, mise en oeuvre sous atmosphère sèche de dioxygène et/ou de diazote. On entend par « atmosphère sèche de dioxygène et/ou de diazote » une atmosphère sous pression partielle faible ou nulle de vapeur d'eau (par exemple inférieure à environ 10⁻⁵ mbar). Par rapport à une oxydation du matériau getter se produisant en exposant le matériau getter à l'air ambiant, l'oxydation et/ou la nitruration réalisées par voie sèche, c'est-à-dire réalisées dans un environnement clos comportant de l'oxygène sec et/ou du diazote sec, ne diffusent pas de molécules d'hydrogène dans le matériau getter. Ainsi, aucun dégazage pour éliminer spécifiquement ces molécules d'hydrogène n'est nécessaire.

La couche de protection 106 d'oxyde et/ou de nitrure peut absorber et/ou adsorber de façon réversible des molécules gazeuses, par exemple celles de l'air ambiant, protégeant ainsi toute la surface du matériau getter 104 de toute altération par ces molécules gazeuses lors de la réalisation du substrat 100. Une telle couche de protection 106 permet donc d'augmenter la capacité de pompage du matériau getter par rapport à un matériau getter non protégé et exposé à l'air ambiant. De plus, le matériau getter 104 ainsi protégé peut être activé thermiquement à partir d'une température d'activation thermique plus basse, par exemple inférieure d'environ 20°C à 30°C par rapport à la température d'activation d'un matériau getter de nature similaire non protégé et exposé à l'air ambiant.

Lorsque la couche de protection 106 comporte de l'oxyde, l'étape d'oxydation peut être mise en oeuvre à une pression supérieure à environ 10⁻² mbar et/ou à une température supérieure ou égale à environ 50°C et/ou pendant une durée comprise entre environ 1 mn et 10 mn, notamment lorsque le matériau getter 104 comporte du titane et/ou du zirconium. Ces paramètres correspondent au fait que la cinétique d'oxydation du titane dans cette gamme de températures reste la même.

De plus, la surface peut apparaître saturée en espèces adsorbées à partir d'environ 10⁻² mbar pour un temps d'exposition proche d'une minute. Ainsi, en choisissant une température supérieure ou égale à environ 50°C, par exemple égale à environ 100°C, on forme une couche de protection 106 suffisamment épaisse pour absorber et/ou adsorber les molécules gazeuses auxquelles le matériau getter est susceptible d'être exposé. La couche de protection 106 ainsi formée peut avoir une épaisseur comprise entre environ un et quelques nanomètres, par exemple comprise entre environ 1 nm et 10 nm.

Lorsque la couche de protection 106 comporte du nitrure, l'étape de nitruration peut être réalisée selon des paramètres similaires à ceux indiqués ci-dessus pour une oxydation, et de préférence à une température comprise entre environ 100°C et 120°C, et/ou pendant une durée comprise entre environ 1 mn et 10 mn et/ou à une pression supérieure à environ 10⁻² mbar, notamment lorsque le matériau getter comporte du titane et/ou du zirconium.

Les paramètres indiqués ci-dessus peuvent également s'appliquer pour des matériaux getter autres que le titane ou le zirconium.

Il est également possible que la couche de protection 106 comporte un matériau autre qu'un oxyde ou un nitrure. Ainsi, lorsque la couche getter 104 comporte par exemple du titane ou du zirconium, la couche de protection peut être composée de chrome et avoir une épaisseur égale à quelques dizaines de nanomètres, par exemple comprise entre environ 10 nm et 100 nm. Dans ce cas, lors de la thermocompression réalisée ultérieurement, on s'assurera que le getter ainsi protégé diffuse dans le chrome de façon à être présent en surface.

Parallèlement à la réalisation des couches 104 et 106 sur le premier support 102, on réalise sur un second support 108 formé ici par un substrat similaire au support 102, une seconde couche 110 de matériau getter elle-même recouverte d'une seconde couche de protection 112. Les matériaux getter des couches 104 et 110 peuvent être similaires ou non. En réalisant les couches 104 et 110 à partir de matériaux getter différents, il est possible d'avoir alors deux températures d'activation thermique différentes. Ainsi, le getter peut être activé à deux reprises, ce qui permet d'obtenir une plus grande capacité de pompage. Il est possible d'assembler les deux couches getter telles que le matériau getter présentant la température d'activation thermique la plus basse soit destiné à être exposé à l'atmosphère de la cavité, et que l'autre matériau getter (de plus haute température d'activation thermique) soit disposé sous le getter de plus basse température. Ainsi, le getter de plus basse température peut être « régénéré » lors de l'activation thermique du getter de plus haute température d'activation.

De plus, la seconde couche de protection 112 peut comporter de l'oxyde et/ou du nitrure du matériau getter de la seconde couche getter 110.

Préalablement à la réalisation des couches de protection 106 et 112, il est possible de mettre en oeuvre une opération de nettoyage des couches getter 104, 110, par exemple par bombardement d'ions d'un gaz rare, et/ou de pré-activation sous vide des couches getter 104, 110.

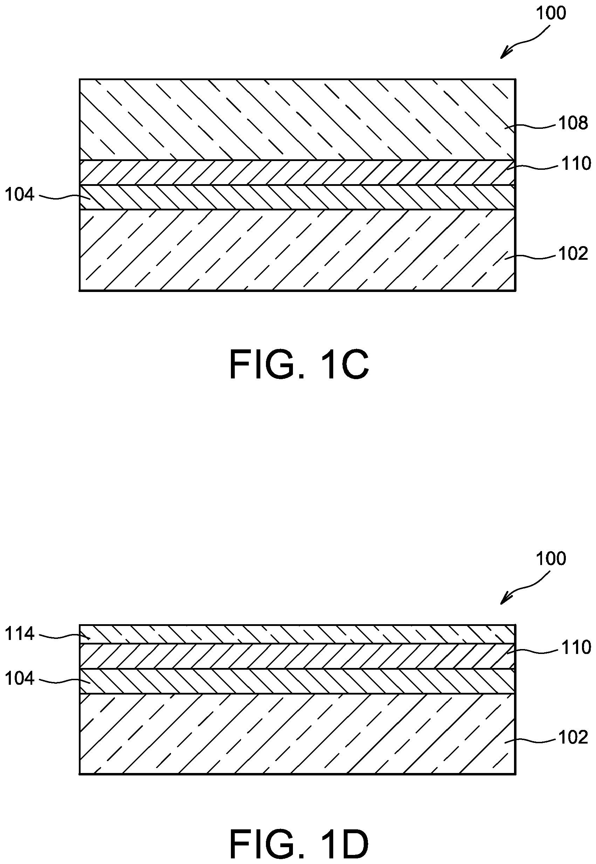

Comme représenté sur la figure 1B, les couches de protection 106 et 112 sont ensuite mises en contact l'une contre l'autre. Les couches de protection 106 et 112 sont mises en pression l'une contre l'autre et subissent un traitement thermique (thermocompression) jusqu'à ce que ces couches de protection 106 et 112 disparaissent et qu'une liaison métal / métal entre les couches de matériaux getter 104 et 110 obtenue par interdiffusion entre les matériaux getter 104 et 110, réalise une solidarisation des couches getter 104, 110 entre elles (figure 1C). Compte tenu de la forte solubilité, notamment de l'oxygène et de l'azote, dans le getter, les oxydes et nitrures sont dissous, dans la gamme des températures des matériaux getter, le long des joints de grains de métal. Les matériaux getter 104 et 110 comportent donc, après la mise en oeuvre de cette thermocompression, des particules dissoutes d'oxygène et/ou d'azote. Lorsque l'une ou les couches de protection 106, 112 comportent du chrome, le phénomène de diffusion de la couche getter vers le chrome correspond à un phénomène de ségrégation de surface qui conduit également à un scellement métal / métal en surface. Ce scellement entre les couches getter 104 et 110 est réalisé sous vide contrôlé (vide secondaire), c'est-à-dire à une pression comprise entre environ 10⁻⁴ mbar et 10⁻⁶ mbar., ce qui permet de préserver la capacité de pompage des getters 104, 110 et d'avoir une forte herméticité et une bonne tenue mécanique entre les deux supports 102, 108.

Etant donné que les couches de matériau getter 104 et 110 sont protégées initialement par les couches de protection 106 et 112, aucune couche d'oxyde ne se forme en surface des couches getter 104 et 110.

Lorsque les couches getter 104 et 110 entrent en contact l'une avec l'autre après la disparition des couches de protection 106 et 112, on obtient donc un contact métal / métal. Cette liaison mécanique formée entre les couches getter 104 et 110 est obtenue grâce à la faible rugosité présentée par les couches getter 104 et 110. Dans le cas présent, cette faible rugosité est obtenue grâce au procédé de dépôt mis en oeuvre (PVD) pour former les couches getter 104 et 110 sur les substrats 102 et 108, ainsi qu'à la faible épaisseur de ces couches getter 104 et 110.

Préalablement à la réalisation des couches de protection 106 et 112, les couches getter 104 et 110 peuvent être soumises à une opération de polissage mécano-chimique (CMP) permettant de réduire la rugosité des couches 104 et 110. Une telle opération peut être mise en oeuvre pour des couches getter dont l'épaisseur est importante, par exemple supérieure ou égale à environ 1 µm. Cette opération de polissage peut être suivie d'une étape de nettoyage des couches de matériau getter, notamment pour retirer l'hydrogène pouvant être apporté par les liquides utilisés lors du polissage, par un traitement sous vide secondaire en température. Après une telle étape, on réalise avantageusement une nouvelle opération d'oxydation ou de nitruration par voie sèche. De plus, lorsque la ou les couches getter sont minces, par exemple d'épaisseur égale ou inférieure à environ 100 nm, la rugosité de telles couches est généralement relativement faible et ne nécessitent pas d'opération de polissage.

Un traitement rendant les surfaces des couches de protection 106 et 112 hydrophiles peut aussi être réalisé, en vue de réaliser un pré-assemblage des couches getter 106, 112 par des forces de Van der Waals, comme dans un procédé de scellement direct silicium/silicium (« Silicon direct Bonding » en anglais, ou SDB), et ainsi réaliser au préalable à la consolidation mécanique en température une étape de pré-collage entre les couches de protection 106 et 112. Un tel traitement hydrophile peut être obtenu par des procédés par voie humide et/ou sèche (plasma d'oxygène ou d'azote) comme ceux mis en oeuvre lors d'un assemblage silicium / silicium par collage moléculaire.

Lorsque les couches de protection 106 et 112 ont été exposées à l'air ambiant avant leur mise en contact l'une contre l'autre, il est possible de réaliser un dégazage en température de ces couches 106, 112, préalablement à leur mise en contact l'une contre l'autre. Ce dégazage peut être obtenu par un traitement thermique par exemple à une température inférieure d'environ 50°C à 150°C par rapport à la température d'activation thermique la plus basse parmi les températures d'activation thermique des matériaux getter 104 et 110, et sous vide secondaire. Un tel traitement thermique permet de désorber les molécules gazeuses qui ont été adsorbées et/ou absorbées par les couches de protection 106 et 112, tout en évitant d'activer les matériaux getter lors de cette phase de dégazage.

Cette étape de dégazage peut être mise en oeuvre pendant une durée comprise entre environ quelques minutes et quelques dizaines de minutes, par exemple entre environ 2 mn et 50 mn.

Après la solidarisation des couches getter 104, 110 entre elles, il est possible de réaliser une opération d'amincissement mécanique puis un polissage par CMP de l'un des deux supports, par exemple le second support 108, afin qu'une partie restante de ce second support 108 forme une couche 114 dont l'épaisseur est choisie en fonction de l'utilisation ultérieure du substrat 100 (figure 1D). Cette épaisseur peut être par exemple comprise entre quelques micromètres et environ 100 µm. Cette couche 114 peut servir par exemple à la réalisation ultérieure de microsystèmes MEMS comportant des éléments formés par gravure dans la couche 114. On obtient donc un substrat 100 dont la géométrie est sensiblement similaire à celle d'un substrat SOI (silicium sur isolant), excepté que le diélectrique enterré est ici remplacé par deux couches getter enterrées.

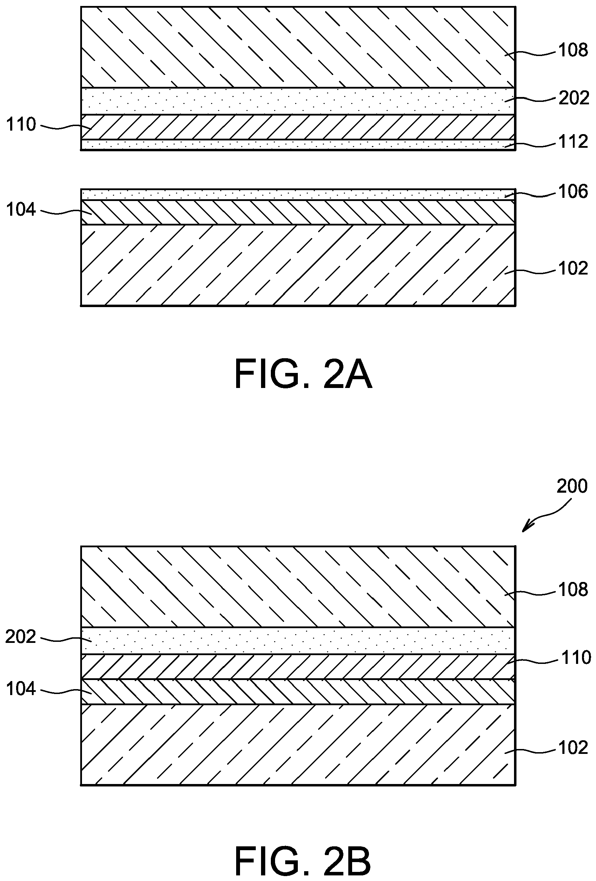

On se réfère aux figures 2A et 2B qui représentent les étapes d'un procédé de réalisation d'un substrat 200 à couches enfouies de matériaux getters selon un second mode de réalisation.

Comme pour le substrat 100 précédemment décrit, on réalise tout d'abord un dépôt pleine plaque de la couche getter 104 sur le premier support 102. La couche de protection 106 comportant de l'oxyde et/ou du nitrure est ensuite réalisée sur la couche getter 104.

Le second support 108 est recouvert d'une couche diélectrique 202 comportant de l'oxyde et/ou du nitrure. Lorsque le support 108 comprend un semi-conducteur tel que du silicium, cette couche 202 est formée par exemple par une oxydation (oxydation en ambiance oxydante ou par un dépôt d'oxyde de type CVD) et/ou une nitruration du second support 108. L'épaisseur de la couche diélectrique 202 est supérieure à celle de la couche de protection 106 et est par exemple comprise entre environ 10 nm et 10 µm. Cette couche diélectrique 202 est ensuite recouverte par la couche de matériau getter 110 et par la couche de protection 112.

Les couches de protection 106 et 112 sont ensuite mises en contact l'une contre l'autre. Une thermocompression est ensuite réalisée entre ces deux couches, de manière analogue au premier mode de réalisation. Cette thermocompression supprime les couches de protection 106 et 112 et forme une liaison mécanique entre les couches getter 104 et 110.

On obtient ainsi un substrat 200 de type SOIAG (silicium sur isolant et getter) comportant deux couches getter 104, 110 enterrées, ainsi qu'une couche diélectrique 202 disposée entre ces couches getter 104, 110 et le support 108 (qui peut ensuite être aminci comme précédemment décrit pour le substrat 100), réalisant notamment une isolation électrique entre le support 108 et les couches getter 104, 110. Dans une variante, il est possible que la couche diélectrique 202 soit disposée entre le premier support 102 et la couche getter 104. Pour la réalisation d'un micro-dispositif résonant réalisé par gravure dans le support 108, la couche diélectrique 202 peut avantageusement servir de couche d'arrêt à la gravure du support 108. La libération d'une partie mobile du micro-dispositif peut ainsi être obtenue par gravure finale de la couche diélectrique 202 et arrêt sur la couche getter 110.

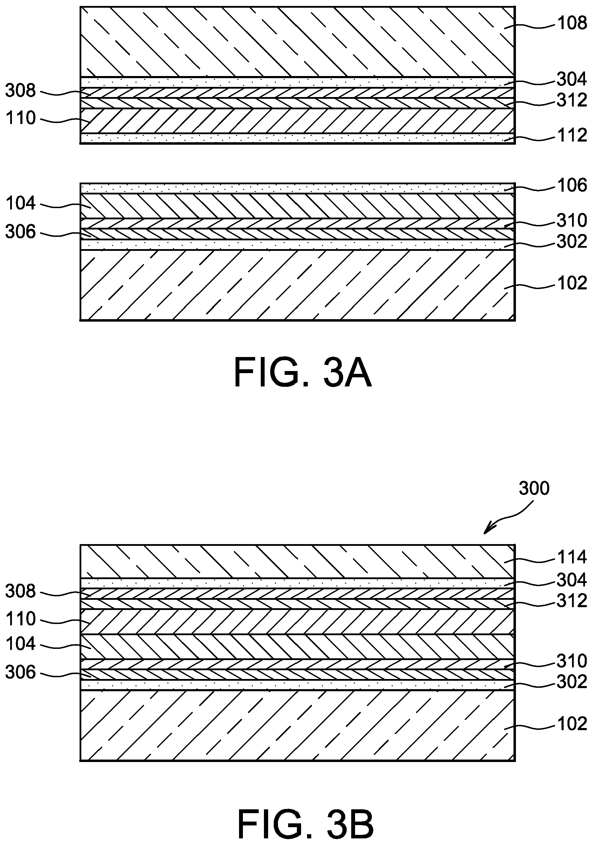

On se réfère aux figures 3A et 3B qui représentent les étapes d'un procédé de réalisation d'un substrat 300 à couches getter enfouies selon un troisième mode de réalisation.

Comme pour les substrats 100 et 200 précédemment décrits, le substrat 300 est réalisé à partir des deux supports 102 et 108, formés par des substrats de silicium. Toutefois, contrairement aux substrats 100 et 200, les couches getter 104 et 110 ne sont pas déposées directement sur les supports 102 et 108. En effet, des couches diélectriques 302 et 304 sont formées au préalable sur les supports 102 et 108.

Ces couches diélectriques 302 et 304 peuvent comporter de l'oxyde et/ou du nitrure, et formées par oxydation et/ou nitruration des supports 102, 108. Ces couches diélectriques 302 et 304 ont par exemple une épaisseur comprise entre quelques dizaines de nanomètres et quelques micromètres.

Des couches d'accroche 306 et 308 sont ensuite réalisées respectivement sur les couches diélectriques 302 et 304. Les couches d'accroche 306, 308 sont par exemple formées par dépôt, ont par exemple une épaisseur comprise entre environ 20 nm et 100 nm et comportent par exemple du titane ou du zirconium. Ces couches d'accroche 306, 308 permettent d'améliorer l'adhérence entre les couches diélectriques 302 et 304 et des couches 310 et 312 destinées à être réalisées sur les couches d'accroche 306, 308.

Les couches 310 et 312 formées sur les couches d'accroche 306, 308 sont destinées à moduler la température d'activation thermique des couches de matériau getter 104 et 110 qui seront formées sur ces couches 310, 312, c'est-à-dire à moduler la température à laquelle ces couches getter 104, 110 sont destinées à réagir avec l'atmosphère présente à l'intérieur de la cavité dans laquelle ces matériaux getter sont destinés à être encapsulés. Les couches 310 et 312 comportent par exemple du cuivre et/ou du nickel et/ou du platine et/ou de l'argent et/ou du ruthénium et/ou du chrome et/ou de l'or et/ou de l'aluminium et peuvent avoir une épaisseur comprise entre environ 50 nm et 500 nm lorsque l'épaisseur des couches getter 104, 110 est comprise entre environ 100 nm et 2000 nm, ou comprise entre environ 10 nm et 100 nm lorsque l'épaisseur des couches getter 104, 110 est comprise entre environ 100 nm et 900 nm. Ces sous-couches d'ajustement 310, 312 peuvent présenter des propriétés mécaniques (élasticité/plasticité) qui vont favoriser le contact ultérieur entre les deux couches getters 104 et 110. D'autres détails et variantes de réalisation de telles couches d'ajustement de la température d'activation thermique sont décrits dans le document WO 2009/087284 A1.

Les couches getter 104 et 110 sont ensuite déposées sur les couches d'ajustement 310 et 312.

Enfin, des couches de protection 106 et 112, similaires à celles précédemment décrites pour la réalisation des substrats 100 et 200, sont formées sur les couches getter 104 et 110 (figure 3A).

De manière analogue aux substrats 100 et 200 précédemment décrits, les couches de protection 106 et 112 sont ensuite mises en contact et thermocompressées l'une contre l'autre afin de faire adhérer les couches getters 104 et 110 entre elles après élimination des couches de protection 106 et 112.

Enfin, le substrat 300 est achevé en réalisant une opération d'amincissement mécanique puis un polissage mécano-chimique du second support 108, formant une couche 114 dont l'épaisseur est choisie en fonction de l'utilisation ultérieure du substrat 300 (figure 3B).

Il est par exemple possible de réaliser des microsystèmes sur et/ou dans la couche 114 amincie, la couche diélectrique 304 servant à la fois de couche d'arrêt de gravure lors de la gravure (par exemple par usinage) de la couche 114, et de couche de libération (par exemple en la gravant par acide fluoridrique sous forme vapeur). Lorsque la couche diélectrique 304 sert de couche sacrificielle pour libérer des parties mobiles de microsystèmes réalisés dans la couche 114, cette couche diélectrique 304 peut être réalisée telle qu'elle ait une épaisseur comprise entre environ 1 µm et 10 µm.

En considérant que les couches de matériaux getter 104 et 110 peuvent comporter ou non un même matériau getter, et que les couches diélectriques 302, 304 peuvent comporter de l'oxyde ou du nitrure, on voit qu'il est possible de réaliser, en combinant ces différentes variantes, une dizaine de variantes du substrat 300.

Pour tous les modes de réalisation précédemment décrits, l'assemblage par thermocompression sous vide secondaire et sous contrainte est réalisé à une température supérieure ou égale à la température d'activation thermique du matériau getter de plus basse température d'activation thermique parmi les matériaux getter des couches 104 et 110. Le matériau getter ainsi activé peut réduire les couches de protection et/ou les couches natives d'oxyde ou de nitrure et ainsi conduire à la création d'une liaison métal/métal entre les couches getter. La température maximale d'assemblage peut correspondre à la température d'activation thermique du getter de plus haute température d'activation. Le tableau ci-dessous indique des exemples de températures d'activation thermique d'une couche getter comprenant du titane, d'épaisseur comprise entre environ 100 nm et 2 µm, en fonction de la nature du matériau de la sous-couche d'ajustement dont l'épaisseur est comprise entre environ 50 nm et 500 nm.

| Sous-couche d'ajustement | Température d'activation |
|---|---|
| Ru | 275°C |
| Cr | 300°C |
| Pt | 325°C |
| Ni | 350°C |
| Au | 365°C |
| Cu | 375°C |
| Ag | 380°C |
| Al | 400°C |

On donne ci-dessous à titre d'exemples des températures pour la réalisation de l'opération d'assemblage par thermocompression pour des couches getter 104 et 110 comprenant du titane, en fonction de la nature des sous-couches d'ajustement se trouvant sous chacune des couches getter.

| T° activation | Cr | Ni | Cu | Al |
|---|---|---|---|---|
| Cr | 300°C | 300-350°C | 300-375°C | 300-400°C |
| Ni | 325°C | 325-350°C | 325-375°C | 325-400°C |
| Cu | | 350°C | 375°C | 350-400°C |
| Al | | | | 400°C |

Un matériau getter comprenant du Ti et/ou du Zr en couche mince s'active par exemple à une température comprise entre environ 200°C et 400°C.

Les variantes précédemment décrites pour la réalisation du substrat 100 (opération d'amincissement mécano-chimique des couches getter en vue de réduire la rugosité du matériau getter, traitement de type hydrophile, dégazage des couches de protection 106 et 112, opération de nettoyage ou encore pré-activation sous vide des couches getter 104, 110) peuvent également être appliquées pour la réalisation des substrats 200 et 300.

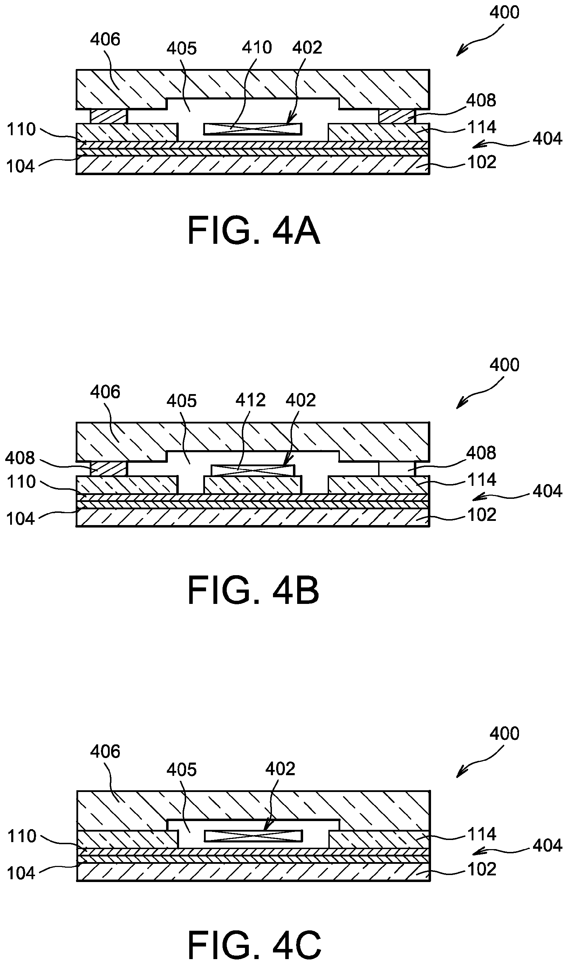

On décrit maintenant, en liaison avec les figures 4A à 4H, différents micro-dispositifs comportant des microsystèmes encapsulés et réalisés à partir d'au moins un substrat à couches getter enfouies ou enterrées. Dans les différents exemples décrits, le ou les substrats à couches getter enfouies correspondent au substrat 100 précédemment décrit.

Toutefois, n'importe quelle variante des substrats 100, 200 ou 300 pourrait être utilisée pour réaliser ces micro-dispositifs.

Un micro-dispositif 400 représenté sur la figure 4A comporte un microsystème 402, par exemple un MEMS, formé dans la couche de silicium 114 d'un substrat 404 similaire au substrat 100 précédemment décrit. Ce microsystème 402 est par exemple obtenu par la mise en oeuvre d'étapes de photolithographie et de gravure de la couche de silicium 114. Lorsque le microsystème 402 comporte une structure résonante, la dernière étape de gravure peut être une gravure profonde ionique réactive (DRIE) dans la couche de silicium 114, formant une masse mobile de la structure résonante. Lorsque le substrat 404 est similaire au substrat 200 ou 300, ou plus généralement lorsque le substrat 404 comporte une ou plusieurs couches de matériaux disposées entre les couches getter 104, 110 et la couche de silicium 114, la libération des éléments du microsystème 402 peut être réalisée en plusieurs étapes de gravure, pour graver sélectivement les différentes couches présentes sous la couche getter. Les couches diélectriques des substrats 200 et 300 précédemment décrits peuvent donc servir de couches d'arrêt de gravure lors de la réalisation de microsystèmes dans ces substrats.

Le microsystème 402 est encapsulé dans une cavité 405 formée entre le substrat 404 et un capot 406 solidarisé à des portions de la couche de silicium 114 par un cordon de scellement 408. Le capot 406 est par exemple formé par un substrat de semi-conducteur.

L'opération de report du capot 406 peut être réalisée par un scellement hermétique sous atmosphère contrôlée afin que cette atmosphère contrôlée se retrouve dans la cavité 405. Comme représenté sur la figure 4A, le microsystème 402 comporte des portions gravées de la couche 114 formant par exemple une ou plusieurs parties mobiles 410 du microsystème 402.

Les parties gravées de la couche 114 dévoilent des portions de la couche getter 110 dans la cavité 405 permettant de contrôler l'atmosphère au sein de la cavité 405. L'activation du getter peut être réalisée pendant le scellement du capot 406 et/ou après ce scellement par un traitement thermique adapté.

Dans une variante de réalisation représentée sur la figure 4B, le microsystème 402 est réalisé sur la couche 114, par exemple à partir d'une ou plusieurs couches de matériaux déposées sur la couche 114 préalablement à la solidarisation du capot 406 au substrat 404. Des portions restantes 412 de cette ou ces couches de matériaux formant le microsystème 402 sont donc disposées sur des portions de la couche 114. Toutefois, certaines parties de la couche 114 sont gravées pour dévoiler une ou plusieurs parties des couches getter 104 et 110 au sein de la cavité 405, et réaliser ainsi un contrôle de l'atmosphère gazeuse de la cavité 405.

Une autre variante de réalisation du micro-dispositif 400 est représentée sur la figure 4C.

Contrairement au micro-dispositif représenté sur les figures 4A et 4B, la solidarisation entre le capot 406 et le substrat 404 n'est pas réalisée par un cordon de scellement. Sur la figure 4C, le capot 406 est solidarisé directement contre la couche 114 du substrat 402. Ainsi, lorsque le capot 406 comporte du semi-conducteur tel que du silicium, cette solidarisation peut être un collage direct silicium / silicium (« Silicon Direct Bonding » en anglais) entre le capot 406 et la couche 114. Lorsque le capot 406 comporte du verre, la solidarisation entre le capot 406 et la couche 114 peut être réalisée par un scellement anodique.

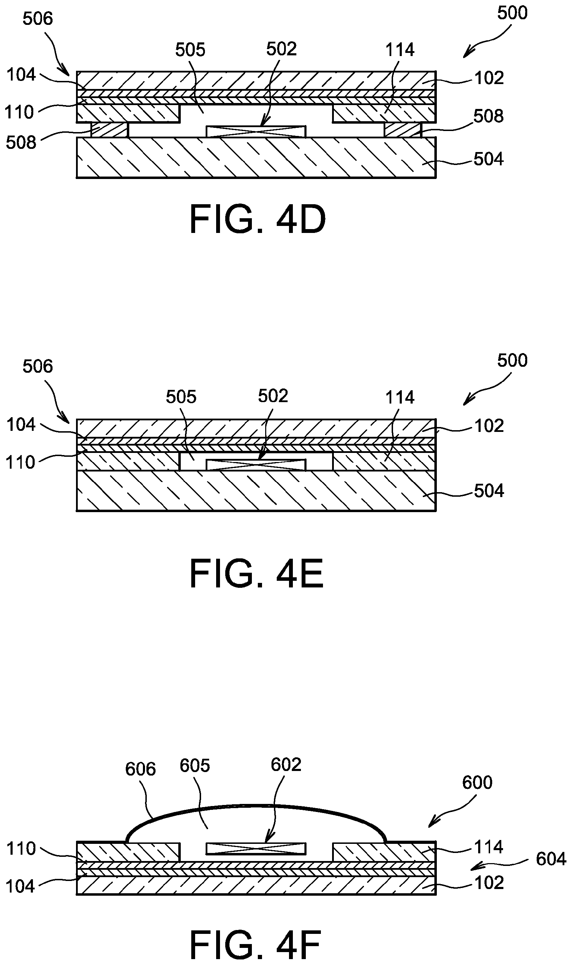

Un micro-dispositif 500 représenté sur la figure 4D comporte un microsystème 502 formé sur un substrat 504 comprenant par exemple du semi-conducteur. Le microsystème 502 est encapsulé dans une cavité 505 formée entre le substrat 504 et un capot formé par un substrat 506 similaire au substrat 100 précédemment décrit et solidarisé au substrat 504 par un cordon de scellement 508. Une partie de la couche 114 du substrat 506 est gravée pour former une partie de la cavité 505, ainsi que pour dévoiler, ou mettre à nue, une partie de la couche getter 110. Ainsi, contrairement au micro-dispositif 400 précédemment décrit, le substrat à couches getter enfouies ne sert pas de support à la réalisation d'un microsystème mais sert à former le capot de la cavité dans laquelle le microsystème est encapsulé.

Dans une variante de réalisation représentée sur la figure 4E, il est possible que la solidarisation entre le substrat 504 et le capot formé par le substrat 506 à couches getter enfouies ne soit pas réalisée par l'intermédiaire d'un cordon de scellement, mais soit réalisée directement entre le substrat 504 et le substrat 506 (par exemple, par collage direct silicium / silicium ou par un scellement anodique). Dans ce cas, la partie gravée de la couche 114 forme la totalité de l'espace de la cavité 505. Il convient donc dans ce cas de réaliser la couche 114 avec une épaisseur suffisante afin de pouvoir réaliser une cavité 505 de hauteur suffisante pour y loger le microsystème 502.

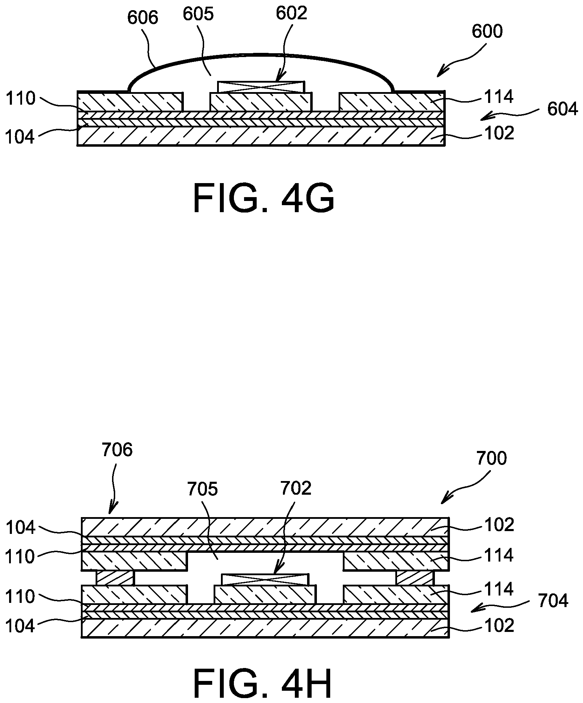

Un micro-dispositif 600 représenté sur les figures 4F et 4G comporte un microsystème 602 formé sur un substrat 604 similaire au substrat 100 précédemment décrit. Contrairement au micro-dispositif 400 représenté sur les figures 4A et 4B, le capot n'est pas formé par un substrat massif solidarisé au substrat 604 mais par une couche mince 606 solidarisée à la couche 114 du substrat 604. Un tel capot peut être formé en recouvrant le microsystème 602 par une couche sacrificielle qui est mise en forme en fonction de l'espace souhaité pour la cavité 605. La couche mince 606 est alors déposée sur le matériau sacrificiel.

Enfin, le matériau sacrificiel est gravé, par exemple à travers une ouverture formée dans le capot 606, cette ouverture étant ensuite bouchée.

Un micro-dispositif 700 représenté sur la figure 4H comporte un microsystème 702 encapsulé dans une cavité 705 formée entre deux substrats 704 et 706 à couches getter enfouies, par exemple similaires au substrat 100 précédemment décrit. Ainsi, les couches 114 des substrats 704 et 706 sont gravées afin de dévoiler une partie de la couche 110 de ces deux substrats 704, 706. Le microsystème 702 est par exemple réalisé dans la couche 114 du substrat 704.

Ainsi, les substrats à couches getter enfouies servent à la fois de support à la réalisation d'un microsystème mais également de capot de la cavité 705 dans laquelle le microsystème 702 est encapsulé.

## Revendications

1. Procédé de réalisation d'un substrat (100, 200, 300) à couches (104, 110) de matériau getter enfouies utilisées pour absorber et/ou adsorber des gaz dans un environnement clos, comprenant au moins les étapes de :
- réalisation d'un premier empilement comportant au moins une couche (104) d'un premier matériau getter disposée sur l'ensemble de la surface d'une face d'un premier support (102),
- réalisation d'un second empilement comportant au moins une couche (110) d'un second matériau getter disposée sur l'ensemble de la surface d'une face d'un second support (108),
- mise en contact et thermocompression du premier empilement contre le second empilement, les couches (104, 110) du premier et du second matériau getter étant disposées entre le premier et le second support (102, 108), à une température supérieure ou égale à la température la plus basse parmi les températures d'activation thermique du premier et du second matériau getter, de façon à solidariser les couches (104, 110) du premier et du second matériau getter entre elles.

2. Procédé selon la revendication 1, dans lequel le premier empilement comporte en outre une couche de protection (106) du premier matériau getter disposée sur la couche (104) du premier matériau getter, et/ou le second empilement comporte en outre une couche de protection (112) du second matériau getter disposée sur la couche (110) du second matériau getter, et dans lequel l'étape de mise en contact et de thermocompression permet de faire diffuser la ou les couches de protection (106, 112) avec la ou les couches (104, 110) de matériau getter sur lesquelles sont disposées les couches de protection (106, 112).

3. Procédé selon la revendication 2, dans lequel la couche de protection (106) du premier matériau getter et/ou la couche de protection (112) du second matériau getter comportent de l'oxyde et/ou du nitrure.

4. Procédé selon la revendication 3, dans lequel la couche de protection (106) du premier matériau getter et/ou la couche de protection (112) du second matériau getter sont réalisées par oxydation et/ou nitruration de la couche (104) du premier matériau getter et/ou de la couche (110) du second matériau getter sous atmosphère sèche de dioxygène et/ou de diazote.

5. Procédé selon l'une des revendications précédentes, dans lequel l'étape de mise en contact et de thermocompression du premier empilement contre le second empilement est mise en oeuvre sous vide secondaire.

6. Procédé selon l'une des revendications précédentes, comportant en outre, après l'étape de mise en contact et de thermocompression, une étape d'amincissement et/ou de polissage du premier support (102) et/ou du second support (108).

7. Procédé selon l'une des revendications précédentes, dans lequel le premier empilement comporte en outre une première couche diélectrique (302) et/ou une couche d'accroché (306) comprenant du titane et/ou du zirconium disposées entre le premier support (102) et la couche (104) du premier matériau getter, et/ou le second empilement comporte en outre une deuxième couche diélectrique (202, 304) et/ou une couche d'accroche (308) comprenant du titane et/ou du zirconium disposées entre le second support (108) et la couche (110) du second matériau getter.

8. Procédé selon l'une des revendications précédentes, dans lequel le premier et/ou le second empilement comportent en outre au moins une couche (310, 312) de cuivre et/ou de nickel et/ou de platine et/ou d'argent et/ou de ruthénium et/ou de chrome et/ou d'or et/ou d'aluminium disposée entre le premier support (102) et la couche (104) du premier matériau getter et/ou le second support (108) et la couche (110) du second matériau getter.

9. Procédé selon l'une des revendications précédentes, comportant en outre, après la réalisation du premier et du second empilement et avant l'étape de mise en contact et de thermocompression, une étape de dégazage des faces desdits empilements destinées à être mises en contact l'une contre l'autre.

10. Procédé selon l'une des revendications précédentes, comportant en outre, lors de la réalisation du premier empilement et/ou lors de la réalisation du second empilement, une étape d'amincissement et/ou de polissage de la couche (104) du premier matériau getter et/ou de la couche (110) du second matériau getter, et/ou, lorsque le premier et/ou le second empilement comportent la couche de protection (106) du premier matériau getter et/ou la couche de protection (112) du second matériau getter, une étape de traitement hydrophile de la couche de protection (106) du premier matériau getter et/ou de la couche de protection (112) du second matériau getter.

11. Procédé de réalisation d'un dispositif (400, 500, 600, 700), comportant au moins les étapes suivantes :
- mise en oeuvre d'un procédé de réalisation d'un premier substrat (404, 506, 604, 704) selon l'une des revendications précédentes,
- réalisation d'un microsystème (402, 502, 602, 702) sur le premier substrat (404, 604, 704) ou sur un second substrat (504),
- gravure d'une partie du premier substrat (404, 506, 604, 704), dévoilant une partie de la couche (104) du premier matériau getter et/ou une partie de la couche (110) du second matériau getter,
et comportant en outre, lorsque le microsystème (402, 502, 602, 702) est réalisé sur le premier substrat (404, 604, 704), une étape d'encapsulation du microsystème (402, 502, 602, 702) dans une cavité (405, 605, 705) formée entre le premier substrat (404, 604, 704) et un capot (406, 606, 706) solidarisé au premier substrat (404, 604, 704), ou, lorsque le microsystème (502) est réalisé sur le second substrat (504), une étape d'encapsulation du microsystème (502) dans une cavité (505) formée entre le second substrat (504) et le premier substrat (506) solidarisé au second substrat (504), ladite partie de la couche (104) du premier matériau getter et/ou ladite partie de la couche (110) du second matériau getter étant disposée dans la cavité (405, 505, 605, 705).

12. Procédé selon la revendication 11, dans lequel, lorsque le procédé de réalisation du premier substrat (404, 604, 704) comporte une étape d'amincissement et/ou de polissage du second support (108), le microsystème (402, 602, 702) est réalisé dans et/ou sur le second support aminci et/ou poli (114).

13. Procédé selon l'une des revendications 11 ou 12, dans lequel le capot (606) comporte une couche mince de matériau.

14. Procédé selon l'une des revendications 11 ou 12, dans lequel le capot (706) comporte un substrat obtenu par la mise en oeuvre d'un procédé de réalisation d'un substrat selon l'une des revendications 1 à 10.

## Patentansprüche

1. Verfahren zur Herstellung eines Substrats (100, 200, 300) mit vergrabenen Schichten (104, 110) aus Gettermaterial, die verwendet werden, um Gase in einer geschlossenen Umgebung zu absorbieren und/oder zu adsorbieren,
umfassend wenigstens die folgenden Schritte:
- Herstellen eines ersten Stapels, umfassend wenigstens eine Schicht (104) aus einem ersten Gettermaterial, die auf der gesamten Oberfläche einer Fläche eines ersten Trägers (102) angeordnet wird,
- Herstellen eines zweiten Stapels, umfassend wenigstens eine Schicht (110) aus einem zweiten Gettermaterial, die auf der gesamten Oberfläche einer Fläche eines zweiten Trägers (108) angeordnet wird,
- Inkontaktbringen und Thermokompression des ersten Stapels gegen den zweiten Stapel, wobei die Schichten (104, 110) des ersten und des zweiten Gettermaterials zwischen dem ersten und dem zweiten Träger (102, 108) angeordnet sind, bei einer Temperatur größer oder gleich der niedrigsten Temperatur aus den thermischen Aktivierungstemperaturen des ersten und des zweiten Gettermaterials, derart, dass die Schichten (104, 110) des ersten und des zweiten Gettermaterials miteinander verbunden werden.

2. Verfahren nach Anspruch 1, bei dem der erste Stapel ferner eine Schutzschicht (106) für das erste Gettermaterial umfasst, die auf der Schicht (104) aus dem ersten Gettermaterial angeordnet ist, und/oder der zweite Stapel ferner eine Schutzschicht (112) für das zweite Gettermaterial umfasst, die auf der Schicht (110) aus dem zweiten Gettermaterial angeordnet ist, und bei dem der Schritt des Inkontaktbringens und der Thermokompression es ermöglicht, die Schutzschicht oder die Schutzschichten (106, 112) mit der oder den Schichten (104, 110) aus Gettermaterial diffundieren zu lassen, auf denen die Schutzschichten (106, 112) angeordnet sind.

3. Verfahren nach Anspruch 2, bei dem die Schutzschicht (106) für das erste Gettermaterial und/oder die Schutzschicht (112) für das zweite Gettermaterial Oxid und/oder Nitrid umfassen.

4. Verfahren nach Anspruch 3, bei dem die Schutzschicht (106) für das erste Gettermaterial und/oder die Schutzschicht (112) für das zweite Gettermaterial durch Oxidation und/oder Nitrierung der Schicht (104) aus dem ersten Gettermaterial und/oder der Schicht (110) aus dem zweiten Gettermaterial in einer trockenen Atmosphäre von Disauerstoff und/oder Distickstoff hergestellt sind.

5. Verfahren nach einem der vorhergehenden Ansprüche, bei dem der Schritt des Inkontaktbringens und der Thermokompression des ersten Stapels gegen den zweiten Stapel unter sekundärem Vakuum durchgeführt wird.

6. Verfahren nach einem der vorhergehenden Ansprüche, ferner umfassend nach dem Schritt des Inkontaktbringens und der Thermokompression einen Schritt des Abdünnens und/oder des Polierens des ersten Trägers (102) und/oder des zweiten Trägers (108).

7. Verfahren nach einem der vorhergehenden Ansprüche, bei dem der erste Stapel ferner eine erste dielektrische Schicht (302) und/oder eine Haftschicht (306) umfasst, umfassend Titan und/oder Zirkon, die zwischen dem ersten Träger (102) und der Schicht (104) aus dem ersten Gettermaterial angeordnet sind, und/oder der zweite Stapel ferner eine zweite dielektrische Schicht (202, 304) und/oder eine Haftschicht (308) umfasst, umfassend Titan und/oder Zirkon, die zwischen dem zweiten Träger (108) und der Schicht (110) aus dem zweiten Gettermaterial angeordnet sind.

8. Verfahren nach einem der vorhergehenden Ansprüche, bei dem der erste und/oder der zweite Stapel ferner wenigstens eine Schicht (310, 312) aus Kupfer und/oder aus Nickel und/oder aus Platin und/oder aus Silber und/oder aus Ruthenium und/oder aus Chrom und/oder aus Gold und/oder aus Aluminium umfassen, die zwischen dem ersten Träger (102) und der Schicht (104) aus dem ersten Gettermaterial und/oder dem zweiten Träger (108) und der Schicht (110) aus dem zweiten Gettermaterial angeordnet sind.

9. Verfahren nach einem der vorhergehenden Ansprüche, ferner umfassend nach der Herstellung des ersten und des zweiten Stapels und vor dem Schritt des Inkontaktbringens und der Thermokompression einen Schritt des Entgasens der Flächen der Stapel, die in Kontakt aneinander gebracht werden sollen.

10. Verfahren nach einem der vorhergehenden Ansprüche, ferner umfassend während der Herstellung des ersten Stapels und/oder während der Herstellung des zweiten Stapels einen Schritt des Abdünnens und/oder des Polierens der Schicht (104) aus dem ersten Gettermaterial und/oder der Schicht (110) aus dem zweiten Gettermaterial, und/oder, wenn der erste und/oder der zweite Stapel die Schutzschicht (106) für das erste Gettermaterial und/oder die Schutzschicht (112) für das zweite Gettermaterial umfassen, einen Schritt der hydrophilen Behandlung der Schutzschicht (106) für das erste Gettermaterial und/oder der Schutzschicht (112) für das zweite Gettermaterial.

11. Verfahren zur Herstellung einer Vorrichtung (400, 500, 600, 700), umfassend wenigstens die folgenden Schritte:
- Durchführen eines Verfahrens zur Herstellung eines ersten Substrats (404, 506, 604, 704) nach einem der vorhergehenen Ansprüche,
- Herstellen eines Mikrosystems (402, 502, 602, 702) auf dem ersten Substrat (404, 604, 704) oder auf einem zweiten Substrat (504),
- Ätzen eines Teils des ersten Substrats (404, 506, 604, 704), wodurch ein Teil der Schicht (104) aus dem ersten Gettermaterial und/oder ein Teil der Schicht (110) aus dem zweiten Gettermaterial freigelegt wird,
und ferner umfassend, wenn das Mikrosystem (402, 502, 602, 702) auf dem ersten Substrat (404, 604, 704) hergestellt wird, einen Schritt des Einkapselns des Mikrosystems (402, 502, 602, 702) in einem Hohlraum (405, 605, 705), der gebildet ist zwischen dem ersten Substrat (404, 604, 704) und einem mit dem ersten Substrat (404, 604, 704) verbundenen Deckel (406, 606, 706), oder, wenn das Mikrosystem (502) auf dem zweiten Substrat (504) hergestellt wird, einen Schritt des Einkapselns des Mikrosystems (502) in einem Hohlraum (505), der gebildet ist zwischen dem zweiten Substrat (504) und dem mit dem zweiten Substrat (504) verbundenen ersten Substrat (506), wobei der Teil der Schicht (104) aus dem ersten Gettermaterial und/oder der Teil der Schicht (110) aus dem zweiten Gettermaterial in dem Hohlraum (405, 505, 605, 705) angeordnet ist/sind.

12. Verfahren nach Anspruch 11, bei dem dann, wenn das Verfahren zur Herstellung des ersten Substrats (404, 604, 704) einen Schritt des Abdünnens und/oder des Polierens des zweiten Trägers (108) umfasst, das Mikrosystem (402, 602, 702) in und/oder auf dem abgedünnten und/oder polierten zweiten Träger (114) hergestellt wird.

13. Verfahren nach einem der Ansprüche 11 oder 12, bei dem der Deckel (606) eine dünne Materialschicht umfasst.

14. Verfahren nach einem der Ansprüche 11 oder 12, bei dem der Deckel (706) ein Substrat umfasst, das erhalten wird durch die Durchführung eines Verfahrens zur Herstellung eines Substrats nach einem der Ansprüche 1 bis 10.

## Claims

1. Method for producing a substrate (100, 200, 300) with buried layers (104, 110) of getter material used for absorbing and/or adsorbing gas in a closed environment, comprising at least the following steps for:
- making a first stack comprising at least one layer (104) of a first getter material, arranged on the entire surface of a face of a first support (102),
- making a second stack comprising at least one layer (110) of a second getter material, arranged on the entire surface of a face of a second support (108),
- bringing the first stack into contact with the second stack and performing thermocompression, the layers (104, 110) of the first and of the second getter material being arranged between the first and the second supports (102, 108), at a temperature greater than or equal to the lowest temperature among the thermal activation temperatures of the first and the second getter materials, so as to bond the layers (104, 110) of the first and second getter materials together.

2. Method according to claim 1, in which the first stack also comprises a protective layer (106) of the first getter material arranged on the layer (104) of the first getter material, and/or the second stack also comprises a protective layer (112) of the second getter material, arranged on the layer (110) of the second getter material, and in which the step bringing the layers into contact and performing thermocompression make the protective layer(s) (106, 112) diffuse with the layer(s) (104, 110) of getter material on which the protective layers (106, 112) are arranged.

3. Method according to claim 2, in which the protective layer (106) of the first getter material and/or the protective layer (112) of the second getter material comprise oxide and/or nitride.

4. Method according to claim 3, in which the protective layer (106) of the first getter material and/or the protective layer (112) of the second getter material are made by oxidation and/or nitridation of the layer (104) of the first getter material and/or the layer (110) of the second getter material under a dry atmosphere of dioxygen and/or dinitrogen.

5. Method according to one of the previous claims, in which the contact creation and thermocompression step between the first stack and the second stack is applied under a secondary vacuum.

6. Method according to one of the previous claims, also comprising a thinning and/or polishing step of the first support (102) and/or the second support (108), after the step to create contact and thermocompression.

7. Method according to one of the previous claims, in which the first stack also comprises a first dielectric layer (302) and/or a bond layer (306) comprising titanium and/or zirconium, arranged between the first support (102) and the layer (104) of the first getter material, and/or the second stack also comprises a second dielectric layer (202, 304) and/or a bond layer (308) comprising titanium and/or zirconium arranged between the second support (108) and the layer (110) of the second getter material.

8. Method according to one of the previous claims, in which the first and/or the second stack also comprises at least one copper and/or nickel and/or platinum and/or silver and/or ruthenium and/or chromium and/or gold and/or aluminium layer (310, 312) arranged between the first support (102) and the layer (104) of the first getter material and/or the second support (108) and the layer (110) of the second getter material.

9. Method according to one of the previous claims, also comprising a step to degas the faces of said stacks that are to be brought into contact with each other, after the first and the second stack have been produced and before the contact creation and thermocompression step.

10. Method according to one of the previous claims, also comprising a thinning and/or polishing step of the layer (104) of the first getter material and/or the layer (110) of the second getter material during the making of the first stack and/or the second stack, and/or when the first and/or second stack comprise(s) the protective layer (106) of the first getter material and/or the protective layer (112) of the second getter material, a step of hydrophilic treatment of the protective layer (106) of the first getter material and/or the protective layer (112) of the second getter material.

11. Method for making a device (400, 500, 600, 700), comprising at least the following steps:
- implement a method to make a first substrate (404, 506, 604, 704) according to one of the previous claims,
- making a micro-system (402, 502, 602, 702) on the first substrate (404, 604, 704) or on a second substrate (504),
- etching part of the first substrate (404, 506, 604, 704), exposing part of the layer (104) of the first getter material and/or part of the layer (110) of the second getter material,
and also comprising a step to encapsulate the micro-system (402, 502, 602, 702) in a cavity (405, 605, 705) formed between the first substrate (404, 604, 704) and a cover (406, 606, 706) bonded to the first substrate (404, 604, 704) when the micro-system (402, 502, 602, 702) is made on the first substrate (404, 604, 704), or a step to encapsulate the micro-system (502) in a cavity (505) formed between the second substrate (504) and the first substrate (506) bonded to the second substrate (504) when the micro-system (502) is made on the second substrate (504), said part of the layer (104) of the first getter material and/or said part of the layer (110) of the second getter material being arranged in the cavity (405, 505, 605, 705).

12. Method according to claim 11, in which, when the method for producing the first substrate (404, 604, 704) comprises a thinning and/or polishing step of the second support (108), the micro-system (402, 602, 702) is made in and/or on the second thinned and/or polished support (114).

13. Method according to one of claims 11 or 12, in which the cover (606) comprises a thin layer of material.

14. Method according to one of claims 11 or 12, in which the cover (706) comprises a substrate obtained by implementing a method for producing a substrate according to one of claims 1 to 10.
